(19) Europäisches Patentamt
European Patent Office
Office européen des brevets

(11) EP 2 408 619 B1

(12) EUROPÄISCHE PATENTSCHRIFT

(45) Veröffentlichungstag und Bekanntmachung des Hinweises auf die Patenterteilung:
**21.09.2016 Patentblatt 2016/38**

(21) Anmeldenummer: **10710269.1**

(22) Anmeldetag: **15.03.2010**

(51) Int Cl.:
***B32B 17/10*** (2006.01) ***H01L 31/048*** (2006.01)
***C08L 29/14*** (2006.01) ***C08K 5/3435*** (2006.01)

(86) Internationale Anmeldenummer:
**PCT/EP2010/053250**

(87) Internationale Veröffentlichungsnummer:
**WO 2010/106000 (23.09.2010 Gazette 2010/38)**

# (54) PHOTOVOLTAIKMODULE ENTHALTEND PLASTIFIZIERTE ZWISCHENSCHICHT-FOLIEN MIT HOHER STRAHLUNGSTRANSMISSION

PHOTOVOLTAIC MODULES COMPRISING PLASTICIZED INTERLAYER FILMS HAVING HIGH RADIATION TRANSMISSION

MODULES PHOTOVOLTAÏQUES CONTENANT DES COUCHES INTERMÉDIAIRES EN FEUILLES PLASTIFIÉES À HAUTE TRANSMISSION DU RAYONNEMENT

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **18.03.2009 DE 102009001629**

(43) Veröffentlichungstag der Anmeldung:
**25.01.2012 Patentblatt 2012/04**

(73) Patentinhaber: **Kuraray Europe GmbH**
**65795 Hattersheim (DE)**

(72) Erfinder: **KELLER, Uwe**
**53177 Bonn (DE)**

(56) Entgegenhaltungen:
**EP-A1- 1 920 941**
**DE-A1- 4 024 330**
**DE-A1-102004 000 026**
**JP-A- 59 213 750**
**US-A- 5 618 863**
**US-A- 5 650 019**
**US-A1- 2007 215 205**
**US-B1- 6 353 042**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 408 619 B1

## Beschreibung

Technisches Gebiet

Die Erfindung betrifft die Herstellung von Photovoltaikmodulen unter Verwendung von weichmacherhaltigen Folien auf Basis von Polyvinylacetal mit hoher Strahlungstransmission im UV-Bereich.

Stand der Technik

Photovoltaikmodule bestehen aus einer photosensitiven Halbleiterschicht, die zum Schutz gegen äußere Einflüsse mit einer transparenten Abdeckung versehen wird. Als photosensitive Halbleiterschicht können monokristalline Solarzellen oder polykristalline, dünne Halbleiterschichten auf einem Träger eingesetzt werden. Dünnschicht-Solarmodule bestehen aus einer photosensitiven Halbleiterschicht, die auf ein Substrat wie z.B. eine transparente Platte oder eine flexible Trägerfolie z.B. durch Aufdampfen, Gasphasenabscheidung, Sputtern oder Nassabscheidung aufgebracht ist.

Beide Systeme werden häufig zwischen eine Glasscheibe und eine rigide, hintere Abdeckplatte z.B. aus Glas oder Kunststoffen mit Hilfe eines transparenten Klebers laminiert.

Der transparente Kleber muss die photosensitive Halbleiterschicht und deren elektrische Verbindungsleitungen vollständig umschließen, UV-stabil sowie unempfindlich gegenüber Feuchtigkeit und nach dem Laminierprozess vollständig blasenfrei sein.

Als transparentes Klebesystem für Photovoltaikmodule werden zunehmend weichmacherhaltige Folien auf Basis von Polyvinylacetalen wie das aus der Verbundglasherstellung bekannte Polyvinylbutyral (PVB) eingesetzt. Die Solarzelleneinheiten werden mit einer oder mehreren PVB-Folien bedeckt und diese unter erhöhtem Druck und erhöhter Temperatur mit den gewünschten Abdeckmaterialien zu einem Laminat verbunden.

Grundsätzlich finden in polymeren Materialien, wie etwa Kunststoffen und Lacken, sogenannte Lichtschutzmittel zum Schutz vor schädigender UV-Strahlung breite Anwendung. Diese können gemäß der unterschiedlichen Schutzmechanismen grob in zwei Klassen eingeteilt werden: **UV-Absorber,** welche UV-Strahlung absorbieren und letztendlich durch Umwandlung in Wärmeenergie unschädlich machen und **Lichtstabilisatoren,** welche die durch UV-Strahlung in polymeren Materialien ausgelösten radikalischen Schädigungsreaktionen unterbrechen.

Die kommerziell bedeutendsten UV-Absorber sind Abkömmlinge des Benzophenons, des Benzotriazols und der Cyanoacrylate, wobei Benzotriazole in aller Regel die beste Langzeitstabilität aufweisen. Zu der Gruppe der Lichtstabilisatoren zählen im Wesentlichen die sogenannten HALS (sterisch gehinderte Amine) oder sterisch gehinderte Aminoether (NOR-HALS).

Polyvinylbutyral ist ein aus gesättigten Einheiten aufgebautes Copolymer, d.h. es enthält olefinische oder aromatische Bindungen maximal als Fehlstelle und weist aus diesem Grund auch keine nennenswerte Absorption im Wellenlängenbereich von 280 - 380 nm (UV-A + UV-B) auf. Des Weiteren werden zur Plastifizierung des PVB überwiegend nicht-aromatische Weichmacher herangezogen, für welche bezüglich UV-Absorption entsprechendes gilt. Damit resultiert eine relativ hohe inhärente UV-Stabilität einer aus PVB und Weichmacher bestehenden Mischung zur Herstellung von Folien. Die Stabilität erhöht sich zusätzlich, wenn die Folie durch darüber befindliches Mineralglas vor dem besonders schädlichen UV-B Anteil der UV-Strahlung teilweise geschützt ist.

Nichtsdestotrotz wird marktübliche PVB-Folie für die Anwendungen Automobil- und Architekturglas regelmäßig mit UV-Absorbern, insbesondere mit Abkömmlingen des Benzotriazols, als Additiv ausgerüstet. Dies hat zweierlei Grund: Zum einem ist ein zusätzliches Herausfiltern von schädlicher UV-A und UV-B Strahlung durch die in der Mitte des Verbundsicherheitsglases (VSG) liegende PVB-Folie als ein über die Sicherheitseigenschaften von VSG hinausgehendes funktionelles Merkmal erwünscht, da hierdurch hinter der Verglasung liegende Materialien in einfacher Weise vor starker Verlichtung bzw. Schädigung geschützt werden. Beispiele hierfür sind Auslagen hinter einer Schaufensterscheibe aus VSG bzw. der unter einer Windschutzscheibe befindliche Armaturenbrettträger in einem Automobil. Zum anderen kann PVB in Abhängigkeit der Qualität der Ausgangsstoffe Polyvinylalkohol bzw. Butyraldehyd und der Prozessführung bei der Synthese und Aufarbeitung Fehlstellen bzw. Verunreinigungen enthalten, welche dessen UV-Stabilität beeinträchtigen. Weiterhin können der Folienformulierung hinzugefügte Additive wie etwa Farbstoffe oder phenolische Antioxidantien UV-empfindlich sein, so dass der Einsatz eines UV-Absorbers zu deren Schutz sinnvoll ist.

Zur Einkapselung von photosensitiven Schichten in Photovoltaikmodulen werden üblicherweise Materialien auf Basis von PVB oder EVA eingesetzt. Aus den o.g. Gründen des Herstellungsverfahrens werden diesen Einkapselungsfolien ebenfalls UV-Absorber zugesetzt. Hierdurch wird die UV-Strahlung ganz oder teilweise absorbiert. Dies schützt zwar das photosensitive Schichtsystem des Photovoltaikmoduls vor Strahlenschäden, setzt aber den für die photosensitiven Schichten verwertbaren Strahlungsanteil herab.

So enthalten kommerziell als Einkapselungsmaterialien verwendete PVB-Folien UV-Absorber des Benzotriazol-Typs (wie z.B. Tinuvin 328)und weisen im Verbund zwischen 2 x 2 mm Weißglas nach EN 410 gemessen eine UV-Transmission von weniger als 0,5 % im Wellenlängenbereich von 280 - 380 nm auf. In ähnlicher Weise enthalten Einkapselungsfolien auf Basis EVA zu dessen Schutz UV-Absorber und weisen daher ähnlich geringe Transmissionswerte für UV-Strahlung auf. Strahlung unterhalb der Wellenlänge von 380 nm steht dadurch bei Verwendung der üblichen PVB-Folien bzw. EVA für die Erzeugung von Photostrom nicht zur Verfügung.

Aufgabe

Aufgabe der vorliegenden Erfindung war es, die UV-Transmission für Verkapselungsfolien für Photovoltaikmodule zu erhöhen, um so die Photostromausbeute von Photovoltaikmodulen bei weitgehend unverändertem Aufbau zu verbessern.

Überraschenderweise wurde gefunden, dass weichmacherhaltige Polyvinylacetalfolie in einer Weise lichtstabil erhalten werden kann, die eine hohe UV-Transmission bei gleichzeitig guter photochemischer Stabilität ermöglicht. Hierdurch kann die Photostromausbeute von Photovoltaikmodulen merklich erhöht werden.

Darstellung der Erfindung

Gegenstand der vorliegenden Erfindung sind daher Photovoltaikmodule, umfassend ein Laminat aus

a) einer transparenten Frontabdeckung
b) einer oder mehreren photosensitiven Halbleiterschichten
c) mindestens eine weichmacherhaltige, auf Polyvinylacetal basierenden Folie und
d) einer rückwärtigen Abdeckung, wobei die weichmacherhaltige, auf Polyvinylacetal basierende Folie eine UV-Transmission von mehr als 35 % aufweist, gemessen im Verbund zwischen zwei Scheiben Weißglas in Stärke 2 mm nach EN 410.

Gemäß EN 410 wird die UV-Transmission im Wellenlängenbereich von 280 - 380 nm bestimmt.

Bevorzugt werden photosensitive Halbleiterschichten eingesetzt, die in diesem Wellenlängenbereich Strahlung absorbieren und in elektrische Energie umwandeln können. Unter anderem wird dies in sog. Tandem-Zellen durch Schichten auf Galliumarsenid/Germanium-, Gallium-Indium-Arsenid- oder Gallium-Indium-Phosphid-Basis erreicht.

Besonders vorteilhaft ist die Verwendung der erfindungsgemäßen Folien für speziell auf UV-Strahlung ansprechende Solarzellen bzw. diese enthaltende Module, welche ansonsten im sichtbaren Bereich des Spektrums transparent sind. Solche Systeme befinden sich derzeit in Entwicklung und sollen zukünftig als transparente Verglasung, welche den schädlichen UV-Anteil des Spektrums herausfiltert und zugleich zur Erzeugung von Photostrom nutzt, Anwendung finden.

Erfindungsgemäß verwendete Folien weisen bevorzugt eine UV-Transmission von mehr als 50 %, gemessen im Verbund zwischen zwei Scheiben Weißglas in Stärke 2 mm nach EN 410, besonders bevorzugt von mehr als 70 % auf.

Dies kann erreicht werden, wenn die Folien c) im Wesentlichen frei von UV-Absorbern sind, d.h. deren Konzentration liegt unter 0,01 Gew.%, bevorzugt unter 0,001 Gew.%, besonders bevorzugt bei 0 Gew.%, jeweils bezogen auf die Folienmischung.

Eine ausreichende UV-Stabilität der erfindungsgemäß verwendeten Folien kann durch Selektion des zur Herstellung des Polyvinylacetals herangezogenen Polyvinylalkohol (PVA) erreicht werden. Liegen bereits auf Stufe des PVA ungesättigte Einheiten in der Polymerkette als Fehlstellen vor, finden sich diese zwangsläufig auch im daraus erzeugten Polyvinylacetal wieder und verschlechtern dessen Lichtstabilität bzw. UV-Transmission. Auf Stufe des PVA können die ungesättigten Einheiten in Form von isolierten oder in Konjugation zueinander oder in Konjugation zu Carbonylbindungen stehenden Doppelbindungen vorliegen. Diese ungesättigten Einheiten im PVA lassen sich durch UV-Spektroskopie nachweisen.

Sehr hohe Anteile an Fehlstellen führen bei Messung des PVA als 4 Gew.%-iger Lösung in $H_2O$ zu Extinktionen bei 280 nm von nahe 1. Zur Herstellung von erfindungsgemäß verwendetem Polyvinylacetal wird daher Polyvinylalkohol eingesetzt, welcher in einer 4 Gew.% wässrigen Lösung bei 280 nm Extinktionswerte von weniger als 0.5, von weniger als 0.3, insbesondere 0.2 und bevorzugt 0.1 aufweist.

Ein weiterer Gegenstand der vorliegenden Erfindung sind daher weichmacherhaltige Folien auf Basis von Polyvinylacetal, wobei das Polyvinylacetal durch säurekatalysierte Acetalisierung von Polyvinylalkohol hergestellt wird, und dieser Polyvinylalkohol in einer 4 Gew.% wässrigen Lösung Extinktionswerte von weniger als 0,5 aufweist.

In der Praxis kann ein Polyvinylacetal als Basisrohstoff für eine Einkapselungsfolie zwar bereits unter optimierten Bedingungen produziert werden, das Vorliegen von einigen Fehlstellen entlang oder am Ende der Polymerketten kann jedoch nicht gänzlich verhindert werden. Deshalb kann es sinnvoll sein, dem Polyvinylacetal bzw. der Folienmischung bei Verzicht auf UV-Absorber ausgewählte Lichtstabilisatoren hinzuzufügen.

Alternativ oder zusätzlich zum weitgehenden Verzicht auf UV-Absorber und/oder zur Verwendung von besonders Fehlstellenarmen PVB können die erfindungsgemäß verwendeten Folien mit einem oder mehreren nicht-aromatischen Lichtstabilisatoren, insbesondere mit sterisch gehinderten (nicht-aromatischen) Aminen vom Typ HALS und/oder sterisch gehinderten (nicht-aromatischen) Aminoethern (NOR-HALS) ausgerüstet werden. Durch die Beschränkung auf nicht-aromatische Produkte wird sichergestellt, dass sich die Transmission der Folie im UV-Bereich von 280 - 380 nm nicht unnötig verschlechtert.

Erfindungsgemäß verwendete Folien enthalten bevorzugt 0,005 - 1 Gew.-%, besonders bevorzugt 0,01 - 0,5 Gew.-%, insbesondere 0,05 - 0,3 Gew.-% und am meisten bevorzugt 0,10 - 0,25 Gew.-% an nicht-aromatischen Lichtstabilisatoren, wie sterisch gehinderten Aminen vom HALS oder NOR-HALS Typ.

Ein weiterer Gegenstand der vorliegenden Erfindung sind daher weichmacherhaltige Folien auf Basis von Polyvinylacetal, wobei sie im Wesentlichen keine aromatischen UV-Absorber und 0,005 bis 1 Gew.% sterisch gehinderte Amine (HALS) und/oder sterisch gehinderte Aminoether (NOR-HALS) enthalten.

Besonders geeignete Amine sind sterisch gehinderte Amine der allgemeinen Formeln I, II und oder III

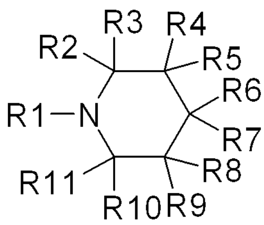

Formel I

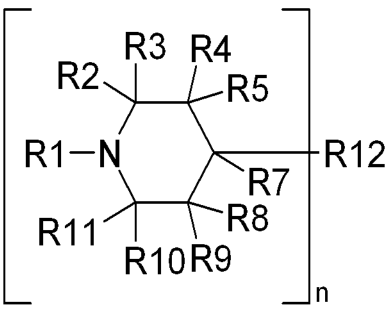

Formel II

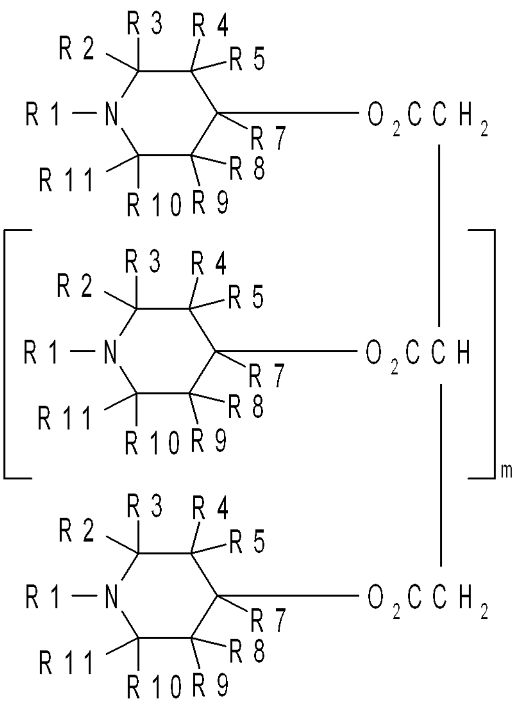

Formel III

mit R1, R2, R3, R4, R5, R6, R7, R8, R9, R10, R11 = nicht-aromatische Substituenten wie H, C1 - C20 Alkyl,

Hydroxyalkyl, Alkoxyalkyl, Acyloxyalkyl, jeweils unsubstituiert oder durch Aldehyd-, Keto- oder Epoxidgruppen substituiert,

R12 = glatte Verbindung, C1 - C20 Alkyl, Hydroxyalkyl, Alkoxyalkyl, Acyloxyalkyl, jeweils unsubstituiert oder durch Aldehyd-, Keto- oder Epoxidgruppen substituiert

$$n = 2 - 4$$

$$m = 1 – 10.$$

Verbindungen dieser Art sind kommerziell erhältlich, beispielsweise durch die Produkte Tinuvin 123 (NOR-HALS), Tinuvin 144, Tinuvin 622, Tinuvin 770 der Fa. Ciba Specialities. Besonders gut geeignet sind beispielsweise ADK Stab LA-57, LA-52 oder LA-62 der Fa. Asai Denka Co. oder UVINUL 4050 H der BASF AG. Weniger geeignet sind Sanduvor PR-31 oder Chimasorb 119 aufgrund ihrer ungesättigten Molekülbestandteile (Sanduvor PR-31: Anisolrest; Chimasorb 119: Triazinring), welche zu hoher Absorption im UV-Bereich führen.

Zur Herstellung von Polyvinylacetal wird Polyvinylalkohol in Wasser gelöst und mit einem Aldehyd wie z.B. Butyraldehyd, Formaldehyd oder Propionaldehyd unter Zusatz eines Säurekatalysators acetalisiert. Das ausgefallene Polyvinylacetals wird abgetrennt, neutral gewaschen, ggf. in einem alkalisch eingestellten wässrigen Medium suspendiert, danach erneut neutral gewaschen und getrocknet.

Die zur Acetalisierung eingesetzte Säure muss nach erfolgter Reaktion wieder neutralisiert werden. Ein geringer Gehalt an Alkalimetallionen kann unter anderem bei der Synthese des Polyvinylacetals durch Verzicht auf die üblicherweise zur Neutralisation des Katalysators angewandten Natrium- oder Kaliumhydroxide bzw. Carbonate oder durch gründliches Waschen des bei der Acetalisierung erhaltenen Polyvinylacetals erzielt werden. Alternativ zu den Basen NaOH oder KOH, kann die Katalysatorsäure aus dem Acetalisierungsschritt z.B. durch Einblasen von Kohlendioxid oder Ethylenoxid neutralisiert werden.

Der Polyvinylalkoholgehalt des Polyvinylacetals kann durch die Menge des bei der Acetalisierung eingesetzten Aldehyds eingestellt werden.

Es ist auch möglich, die Acetalisierung mit anderen oder mehreren Aldehyden mit 2-10 Kohlenstoffatomen (z.B. Valeraldehyd) durchzuführen.

Die auf weichmacherhaltigem Polyvinylacetal basierenden Folien enthalten bevorzugt unvernetztes Polyvinylbutyral (PVB), das durch Acetalisierung von Polyvinylalkohol mit Butyraldehyd gewonnen wird.

Der Einsatz von vernetzten Polyvinylacetalen, insbesondere vernetztem Polyvinylbutyral (PVB) ist ebenso möglich. Geeignete vernetzte Polyvinylacetale sind z.B. in EP 1527107 B1 und WO 2004/063231 A1 (thermische Selbstvernetzung von Carboxylgruppenhaltigen Polyvinylacetalen), EP 1606325 A1 (mit Polyaldehyden vernetzte Polyvinylacetale) und WO 03/020776 A1 (mit Glyoxylsäure vernetzte Polyvinylacetale) beschrieben. Auf die Offenbarung dieser Patentanmeldungen wird vollumfänglich Bezug genommen.

Als Polyvinylalkohol können im Rahmen der vorliegenden Erfindung auch Terpolymere aus hydrolysierten Vinylacetat/Ethylen-Copolymeren eingesetzt werden. Diese Verbindungen sind in der Regel zu mehr als 98 Mol% hydrolysiert und enthalten 1 bis 10 Gew. auf Ethylen basierende Einheiten (z.B. Typ "Exceval" der Kuraray Europe GmbH).

Als Polyvinylalkohol können im Rahmen der vorliegenden Erfindung weiterhin auch hydrolysierte Copolymere aus Vinylacetat und mindestens einem weiteren ethylenisch ungesättigten Monomer eingesetzt werden.

Die Polyvinylalkohole können im Rahmen der vorliegenden Erfindung rein oder als Mischung von Polyvinylalkoholen mit unterschiedlichem Polymerisationsgrad oder Hydrolysegrad eingesetzt werden.

Polyvinylacetale enthalten neben den Acetaleinheiten noch aus Vinylacetat und Vinylalkohol resultierende Einheiten. Die erfindungsgemäß verwendeten Polyvinylacetale weisen bevorzugt einen Polyvinylalkoholanteil von weniger als 22 Gew.%, 20 Gew.% oder 18 Gew.%, weniger als 16 Gew.% oder 15 Gew.% und insbesondere weniger als 14 Gew.% auf. Ein Polyvinylalkoholanteil von 12 Gew.% sollte nicht unterschritten werden.

Der Polyvinylacetatgehalt des erfindungsgemäß eingesetzten Polyvinylacetals liegt bevorzugt unter 5 Gew.%, unter 3 Gew.% oder unter 1 Gew.%, besonders bevorzugt unter 0,75 Gew.%, ganz besonders bevorzugt unter 0,5 Gew.% und insbesondere unter 0,25 Gew.%.

Aus dem Polyvinylalkoholanteil und dem Restacetatgehalt kann der Acetalisierungsgrad rechnerisch ermittelt werden.

Bevorzugt weisen die Folien einen Weichmachergehalt von maximal 40 Gew.%, 35 Gew.%, 32 Gew.%, 30 Gew.%, 28 Gew.%, 26 Gew.%, 24 Gew.%, 22 Gew.%, 20 Gew.%, 18 Gew.%, 16 Gew.% auf, wobei ein Weichmachergehalt von 15 Gew.% aus Gründen der Verarbeitbarkeit der Folie nicht unterschritten werden sollte (jeweils bezogen auf die gesamte Folienformulierung). Erfindungsgemäße Folien bzw. Photovoltaikmodule können einen oder mehrere

Weichmacher enthalten.

Grundsätzlich geeignete Weichmacher für die erfindungsgemäß eingesetzten Folien sind eine oder mehrere Verbindungen ausgewählt aus den folgenden Gruppen:

Ester von mehrwertigen aliphatischen oder aromatischen Säuren, z.B. Dialkyladipate wie Dihexyladipat, Dioctyladipat, Hexylcyclohexyladipat, Mischungen aus Heptyl- und Nonyl-adipaten, Diisononyladipat, Heptylnonyl-adipat sowie Ester der Adipinsäure mit cycloaliphatischen oder Etherbindungen enthaltenden Esteralkoholen, Dialkylsebazate wie Dibutylsebazat sowie Ester der Sebazinsäure mit cycloaliphatischen oder Etherbindungen enthaltenden Esteralkoholen, Estern der Phthalsäure wie Butylbenzylphthalat oder Bis-2-butoxyethylphthalat

Ester oder Ether von mehrwertigen aliphatischen oder aromatischen Alkoholen oder Oligoetherglykolen mit einem oder mehreren unverzweigten oder verzweigten aliphatischen oder aromatischen Substituenten, wie z.B. Estern von Di-, Tri- oder Tetraglykolen mit linearen oder verzweigten ali-phatischen oder cycloaliphatischen Carbonsäuren; Als Beispiele für letztere Gruppe können dienen
Diethylenglykol-bis-(2-ethyl-hexanoat),
Triethylenglykol-bis-(2-ethyl-hexanoat),
Tri-ethylen-glykol-bis-(2-ethylbu-ta-no-at),
Tetra-ethylen-glykol-bis-n-heptanoat, Triethylengly-kol-bis-n-heptanoat,
Triethylenglykol-bis-n-hexanoat, Tetraethylen-glykol-dimethyl-ether
und/oder Dipropylenglykolbenzoat

Phosphate mit aliphatischen oder aromatischen Esteralkoholen wie z.B. Tris(2-ethylhexyl)phosphat (TOF), Triethylphosphat, Diphenyl-2-ethylhexylphosphat, und/oder Trikresylphosphat

Ester der Zitronensäure, Bernsteinsäure und/oder Fumarsäure.

Gut geeignet als Weichmacher für die erfindungsgemäß eingesetzten Folien sind eine oder mehrere Verbindungen ausgewählt aus der folgenden Gruppe Di-2-ethylhexylsebacat (DOS), Di-2-ethylhexyladipat (DOA), Dihexyladipat (DHA), Dibutylsebacat (DBS), Triethylenglykol-bis-n-heptanoat (3G7), Tetraethylenglykol-bis-n-heptanoat (4G7), Triethylenglykol-bis-2-ethylhexanoat (3GO bzw. 3G8) Tetraethylenglykol-bis-n-2-ethylhexanoat (4GO bzw. 4G8) Di-2-butoxy-ethyl-adipat (DBEA), Di-2-butoxyethoxyethyladipat (DBEEA) Di-2-butoxyethylsebacat (DBES), Di-2-ethylhexylphthalat (DOP), Di-isononylphthalat (DINP) Triethylenglykol-bis-isononanoat, Triethylenglykol-bis-2-propylhexanoat, Tris(2-ethylhexyl)phosphat (TOF), 1,2-Cyclohexandicarbonsäurediisononylester (DINCH) und Dipropylenglykolbenzoat.

Ganz besonders geeignet als Weichmacher für die erfindungsgemäß eingesetzten Folien sind Weichmacher, deren Polarität, ausgedrückt durch die Formel 100 x O/(C+H) kleiner/gleich 9.4 ist, wobei O, C und H für die Anzahl der Sauerstoff-, Kohlenstoff- und Wasserstoffatome im jeweiligen Molekül steht. Die nachfolgende Tabelle 1 zeigt erfindungsgemäß einsetzbare Weichmacher und deren Polaritätswerte nach der Formel 100 x O/(C+H).

**Tabelle 1**

| Name | Polaritätswert |
|---|---|
| Di-2-ethylhexylsebacat (DOS) | 5,3 |
| Diisononylcyclohexandicarbonsäureester (DINCH) | 5,4 |
| Di-2-ethylhexyladipat (DOA) | 6,3 |
| Di-2-ethylhexylphthalat (DOP) | 6,5 |
| Dihexyladipat (DHA) | 7,7 |
| Dibutylsebacat (DBS) | 7,7 |
| Triethylenglykol-bis-2-propylhexanoat | 8,6 |
| Triethylenglykol-bis-i-nonanoat | 8,6 |
| Di-2-butoxyethylsebacat (DBES) | 9,4 |
| Triethylenglykol-bis-2-ethylhexanoat (3G8) | 9,4 |

Bevorzugt enthält die erfindungsgemäß eingesetzte Folie c) mehr als 10 ppm, bevorzugt mehr als 20 ppm, bevorzugt mehr als 30 ppm, bevorzugt mehr als 50 ppm, bevorzugt mehr als 75 ppm, bevorzugt mehr als 100 ppm, bevorzugt mehr als 125 ppm und besonders bevorzugt mehr als 150 ppm Ionen ausgewählt aus der Gruppe der Erdalkalimetalle (Be, Mg, Ca, Sr, Ba, Ra), Zink und Aluminium. Um unerwünschte Trübung zu vermeiden, sollten andererseits aber nicht mehr als 1000 ppm der genannten mehrwertigen Metalle enthalten sein.

Gleichzeitig ist der Gehalt an Alkalimetallionen (Li, Na, K, Rb, Cs, Fr) in der weichmacherhaltigen, auf Polyvinylacetal basierenden Folie möglichst niedrig einzustellen. Bevorzugt enthält die Folie weniger als 150 ppm, bevorzugt weniger als 100 ppm, bevorzugt weniger als 75 ppm, bevorzugt weniger als 50 ppm, bevorzugt weniger als 25 ppm, bevorzugt weniger als 10 ppm und besonders bevorzugt weniger als 5 ppm Alkalimetallionen.

Die jeweiligen Erdalkalimetall-, Zink-, Aluminium- bzw. die Alkalimetallionen liegen in der Folie in Form der Salze von ein- oder mehrwertigen anorganischen oder ein- oder mehrwertigen organischen Säuren vor. Beispiele für Gegenionen sind z.B. Salze organischer Carbonsäuren wie etwa Formiate, Acetate, Trifluoracetate, Propionate, Butyrate, Benzoate, 2-Ethylhexanoate usw., wobei bevorzugt Carbonsäuren mit weniger als 10 C-Atomen, bevorzugt weniger als 8, bevorzugt weniger als 6, bevorzugt weniger als 4 und besonders bevorzugt mit weniger als 3 C-Atomen verwendet werden. Beispiele für anorganische Gegenionen sind Chloride, Nitrate, Sulfate, Phosphate.

Bevorzugt weisen die erfindungsgemäß eingesetzten Folien bei einer Umgebungsfeuchte von 85% rF bei 23°C einen spezifischen Widerstand von mindestens 1 E+11 ohm*cm, bevorzugt mindestens 5E+11 ohm*cm, bevorzugt 1 E+12 ohm*cm, bevorzugt 5E+12 ohm*cm, bevorzugt 1 E+13, bevorzugt 5E+13 ohm*cm, bevorzugt 1 E+14 ohm*cm auf.

Weiterhin kann die möglicherweise vom Wassergehalt der Folie abhängende Ionenbeweglichkeit und damit der spezifische Widerstand durch den Zusatz von Kieselsäure, insbesondere pyrogenes $SiO_2$ beeinflusst werden. Bevorzugt enthalten die weichmacherhaltigen, auf Polyvinylacetal basierenden Folien 0.001 bis 15 Gew.%, bevorzugt 0.01 bis 10 Gew.% und insbesondere 2 bis 5 Gew.% $SiO_2$.

Weiterhin können die erfindungsgemäßen Folien zusätzlich auch übliche Additive, wie zum Beispiel Oxidationsstabilisatoren, Farbstoffe, Pigmente sowie Antihaftmittel enthalten, sofern diese die UV-Transmission nicht negativ beeinflussen.

Die prinzipielle Herstellung und Zusammensetzung von Folien auf Basis von Polyvinylacetalen ist z. B. in EP 185 863 B1, EP 1 118 258 B1 WO 02/102591 A1, EP 1 118 258 B1 oder EP 387 148 B1 beschrieben.

Die Herstellung der Photovoltaikmodule kann durch Laminierung der transparenten Frontabdeckung a), den photosensitiven Halbleiterschichten b) und der rückwärtigen Abdeckung d) mittels mindestens einer weichmacherhaltigen, auf Polyvinylacetal basierenden Folie c) unter Verschmelzung der Folien erfolgen, so dass ein blasen- und schlierenfreier Einschluss der photosensitiven Halbleiterschicht erhalten wird.

In dieser Variante der erfindungsgemäßen Photovoltaikmodule werden die photosensitiven Halbleiterschichten b) zwischen zwei Folien c) eingebettet und mit der transparenten Frontabdeckung a) sowie der rückwärtigen Abdeckung d) verklebt.

Insbesondere bei Dünnschicht-Solarmodulen ist die photosensitive Halbleiterschicht direkt auf einen Träger aufgebracht (z.B. durch Aufdampfen, Gasphasenabscheidung, Sputtern oder Nassabscheidung). Eine Einkapselung ist hier nicht möglich. In einem solchen erfindungsgemäßen Modul ist daher eine oder mehrere photosensitive Halbleiterschicht b) auf eine transparente Frontabdeckung a) oder eine rückwärtige Abdeckung d) aufgebracht und durch mindestens einer weichmacherhaltigen, auf Polyvinylacetal basierenden Folie c) miteinander verklebt.

In der Regel wird bei Dünnschicht-Modulen die photosensitive Halbleiterschicht ganzflächig auf den Träger aufgebracht d.h. bis zum Rand des Trägers. Anschließend wird am Rand ein Teil der photosensitiven Halbleiterschicht wieder entfernt, sodass zu Isolationszwecken ein Halbleiter-freier Randbereich übrig bleibt (sog. Randentschichtung). Durch die hohen Widerstandswerte der erfindungsgemäß eingesetzten Folie kann dieser Randbereich mit bevorzugt unter 3 cm, ganz besonders unter 2 cm und insbesondere unter 1 cm sehr schmal ausfallen.

Erfindungsgemäß eingesetzte Folien füllen während des Laminierprozesses die an den photosensitiven Halbleiterschichten bzw. deren elektrischen Verbindungen vorhandenen Hohlräume aus.

Die Dicke der auf weichmacherhaltigem Polyvinylacetal basierenden Folien liegt üblicherweise bei 0.38, 0.51, 0.76, 1.14, 1.52 oder 2.28 mm.

Die transparente Frontabdeckung a) besteht in der Regel aus Glas oder PMMA. Die rückwärtige Abdeckung d) des erfindungsgemäßen Photovoltaikmoduls kann aus Glas, Kunststoff oder Metall oder deren Verbünden bestehen, wobei mindestens einer der Träger transparent sein kann. Es ist ebenfalls möglich, einen oder beide Abdeckungen als Verbundverglasung (d. h. als Laminat aus mindestens zwei Glasscheiben und mindestens einer PVB-Folie) oder als Isolier-verglasung mit einem Gaszwischenraum auszuführen. Selbstverständlich ist auch die Kombination dieser Maßnahmen möglich.

Die in den Modulen eingesetzten photosensitiven Halbleiterschichten müssen keine besonderen Eigenschaften besitzen. Es können mono-, polykristalline oder amorphe Systeme eingesetzt werden.

Zur Laminierung der so erhaltenen Schichtkörpers können die dem Fachmann geläufigen Verfahren mit und ohne vorhergehende Herstellung eines Vorverbundes eingesetzt werden.

So genannte Autoklavenprozesse werden bei einem erhöhten Druck von ca. 10 bis 15 bar und Temperaturen von 130 bis 145 °C über ca. 2 Stunden durchgeführt. Vakuumsack- oder Vakuumring-verfahren z.B. gemäß EP 1 235 683 B1 arbeiten bei ca. 200 mbar und 130 bis 145 °C

Vorzugsweise werden zur Herstellung der erfindungsgemäßen Photovoltaikmodule Vakuumlaminatoren eingesetzt. Diese bestehen aus einer beheizbaren und evakuierbaren Kammer, in denen Verbund-verglasungen innerhalb

von 30 - 60 Minuten laminiert werden können. Verminderte Drücke von 0,01 bis 300 mbar und Temperaturen von 100 bis 200 °C, insbesondere 130 - 160 °C haben sich in der Praxis bewährt.

Alternativ kann ein so oben beschrieben zusammengelegter Schichtkörper zwischen mindestens einem Walzenpaar bei einer Temperatur von 60 bis 150 °C zu einem erfindungsgemäßen Modul verpresst werden. Anlagen dieser Art sind zur Herstellung von Verbundverglasungen bekannt und verfügen normalerweise über mindestens einen Heiztunnel vor bzw. nach dem ersten Presswerk bei Anlagen mit zwei Presswerken.

Weiterhin ist Gegenstand der Erfindung die Verwendung von weichmacherhaltigen, auf Polyvinylacetal basierenden Folien mit einer UV-Transmission von mehr als 35 %, bestimmt zwischen zwei Scheiben Weißglas von 2 mm Dicke nach EN410 zur Herstellung von Photovoltaikmodulen.

Erfindungsgemäße Photovoltaikmodule können als Fassadenbauteil, Dachflächen, Wintergartenabdeckung, Schallschutzwand, Balkon- oder Brüstungselement oder als Bestandteil von Fensterflächen verwendet werden.

Messmethoden:

Die Messung des spezifischen Durchgangswiderstandes der Folie erfolgt gemäß DIN IEC 60093 bei definierter Temperatur und Umgebungsfeuchte (23 °C und 85% rLF) nachdem die Folie wenigstens 24h bei diesen Bedingungen konditioniert wurde. Zur Durchführung der Messung wurde eine Plattenelektrode Typ 302 132 von der Firma Fetronic GmbH sowie ein Widerstandsmessgerät ISO-Digi 5kV von der Firma Amprobe verwendet. Die Prüfspannung betrug 2,5kV, die Wartezeit nach Anlegen der Prüfspannung bis zur Messwerterfassung 60 sek. Damit ein ausreichender Kontakt zwischen den flachen Platten der Messelektrode und der Folie gewährleistet ist, sollte deren Oberflächenrauhigkeit $R_Z$ bei Messung nach DIN EN ISO 4287 nicht größer als 10 mm sein, d.h. gegebenenfalls muss die Originaloberfläche der PVB-Folie vor der Widerstandsmessung durch thermisches Umprägen geglättet werden.

Der Polyvinylalkohol- und Polyvinylalkoholacetatgehalt der Polyvinylacetale wurde gemäß ASTM D 1396-92 bestimmt. Die Analyse des Metallionengehaltes erfolgte durch Atomabsorptionsspektroskopie (AAS). Der Wasser- bzw. Feuchtegehalt der Folien wird mit der Karl-Fischer-Methode bestimmt.

Zur Bestimmung der UV-Absorption des in der Acetalisierung eingesetzten Polyvinylalkohols wird dieser in einem UV/VIS-Spektrometer, z.B. Perkin-Elmer Lambda 910, als 4%-ige wässrige Lösung in einer Schichtdicke von 1 cm bei der Wellenlänge 280 nm vermessen. Dabei ist der Messwert auf den Trockenstoffgehalt des PVA zu beziehen.

Beispiele

Es wurden Folien der Dicke 0,76 mm mit den Mischungen der in den nachfolgenden Tabellen aufgeführten Zusammensetzungen hergestellt und als Laminat zwischen 2 Scheiben Weißglas (Optiwhite) der Stärke 2 mm auf ihre Licht- (380 - 780 nm) und UV-Transmission (280 - 380 nm) gemäß EN 410 untersucht. Der elektrische Durchgangswiderstand wurde nach ausreichender Konditionierung der Folienmuster bei 23 °C / 85% relativer Feuchte wie weiter oben beschrieben bestimmt. Das Auftreten von Blasen bzw. Delaminationen aufgrund von UV-Schädigung wurde an Laminaten der Größe 10 x 10 cm (2 x 2 mm Optiwhite Glas) nach 20-wöchiger Lagerung in einer Bestrahlungskammer gemäß EN 12543 bestimmt, wobei in der Kammer abweichend von den in EN 12543 beschriebenen Bedingungen Probentemperaturen von ca. 80 °C vorherrschten. Folien mit einem Flächenanteil mit Blasen von über 5 % sind unbrauchbar.

Es zeigt sich, dass erfindungsgemäße Folien eine hohe UV Transmission bei gleichzeitig guter Stabilität in der Bestrahlungsprüfung besitzen. Folien dieser Art sind für Photovoltaikanwendungen geeignet, da sie die Photostromausbeute im Bereich 280 bis 380 nm, insbesondere bei Verwendung von blauempfindlichen Solarzellen um ca. 1 % erhöhen.

**Tabelle 2**

| **Beispiel** | **1** | **2** | **3** | **4** | **5** |
|---|---|---|---|---|---|
| PVB | 76 | 76 | 76 | 76 | 76 |
| PVOH-Gehalt des PVB | 20,00 | 20,00 | 20,00 | 20,00 | 20,00 |
| UV-Absorption PVA (1) | 0,10 | 0,06 | 0,10 | 0,10 | 0,10 |
| Weichmacher 3G8 | 24 | 24 | 24 | 24 | 24 |
| Weichmacher DINCH | - | - | - | - | - |
| Tinuvin 328 (2) | - | - | - | - | - |
| Tinuvin 770 DF (3) | - | - | - | 0,15 | 0,3 |
| ADK STAB LA-62 (4) | - | - | 0,15 | - | - |

(fortgesetzt)

| **Beispiel** | **1** | **2** | **3** | **4** | **5** |
|---|---|---|---|---|---|
| Sanduvor PR-31 (5) | - | - | - | - | - |
| Lichtdurchlässigkeit TL [EN410] (6) | 90,5 | 91,2 | 90,8 | 91,3 | 90,1 |
| UV-Transmissionsgrad (280-380 nm) (6) | 71,80 | 72,00 | 63,40 | 73,50 | 72,50 |
| Bestrahlungsprüfung (7) | 4% | 1% | 1% | 0% | 0% |
| Durchgangs- | 3,0 | 3,0 | 3,0 | 3,0 | 3,0 |
| widerstand (8) | E+11 | E+11 | E+11 | E+11 | E+11 |

**Tabelle 3**

| **Beispiel** | **6** | **7** | **8** | **9** | **10** |
|---|---|---|---|---|---|
| PVB | 76 | 74 | 76 | 74 | 78 |
| PVOH-Gehalt des PVB | 14,30 | 14,30 | 14,30 | 14,30 | 14,30 |
| UV-Absorption PVA (1) | 0,10 | 0,10 | 0,10 | 0,10 | 0,10 |
| Weichmacher 3G8 | 24 | - | 24 | - | - |
| Weichmacher DINCH | - | 26 | - | 26 | 22 |
| Tinuvin 328 (2) | - | - | - | - | - |
| Tinuvin 770 DF (3) | - | - | 0,1 | 0,1 | 0,1 |
| ADK STAB LA-62 (4) | - | - | - | - | - |
| Sanduvor PR-31 (5) | - | - | - | - | - |
| Lichtdurchlässigkeit TL [EN410] (6) | 91 | 91,1 | 90,7 | 91 | 90,4 |
| UV-Transmissionsgrad (280-380 nm) (6) | 70,20 | 73,00 | 70,20 | 71,80 | 73,40 |
| Bestrahlungsprüfung (7) | 1% | 1% | 0% | 0% | 0% |
| Durchgangswiderstand (8) | 1,5 E+12 | 1,00 E+14 | 1,5 E+12 | 1,00 E+14 | >3,5 E+14 |

**Tabelle 4**

| Beispiel | VG1 | VG2 | VG3 | VG4 | VG5 | VG6 |
|---|---|---|---|---|---|---|
| PVB | 76 | 76 | 76 | 76 | 76 | 76 |
| PVOH-Gehalt des PVB | 20,00 | 20,00 | 20,00 | 20,00 | 20,00 | 20,00 |
| UV-Absorption PVA(1) | 0,82 | 0,10 | 0,10 | 0,64 | 0,10 | 0,10 |
| Weichmacher 3G8 | 24 | 24 | 24 | 24 | 24 | 24 |
| Weichmacher DINCH | - | - | - | - | - | - |
| Tinuvin 328 (2) | - | 0,05 | 0,15 | 0,15 | 0,3 | - |
| Tinuvin 770 DF (3) | - | - | - | - | - | - |
| ADK STAB LA-62 (4) | - | - | - | - | - | - |
| Sanduvor PR-31 (5) | - | - | - | - | - | 0,15 |
| Lichtdurchlässigkeit TL [EN410] (6) | 87,4 | 90,5 | 90,7 | 88,4 | 91,2 | 90,6 |
| UV-Transmissionsgrad (280-380 nm) (6) | 62,50 | 5,94 | 0,23 | 0,15 | 0,03 | 5,00 |
| Bestrahlungsprüfung (7) | 15% | 0% | 0% | 0% | 0% | 0% |

(fortgesetzt)

| Beispiel | VG1 | VG2 | VG3 | VG4 | VG5 | VG6 |
|---|---|---|---|---|---|---|
| Durchgangswiderstand (8) | 3,0 E+11 | 3,0 E+11 | 3,0 E+11 | 3,0 E+11 | 3,0 E+11 | 3,0 E+11 |

Alle Angaben in den Tabellen sind in Gew.%, bezogen auf die Summe PVB + Weichmacher der Folienmischung. Es bedeuten:

3G8 Triethylenglykol-bis-2-ethylhexanoat DINCH 1,2-Cyclohexandicarbonsäurediisononylester PVB Polyvinylbutyral mit dem angegebenen PVOH-Gehalt

(1) Extinktionswert einer 4 Gew.% wässrigen Lösung bei 280 nm
(2) UV-Absorber vom Benzotriazol-Typ (Ciba Specialities)
(3) HALS ohne ungesättigten Anteil (Ciba Specialities)
(4) HALS ohne ungesättigten Anteil (Asahi-Denka)
(5) HALS mit ungesättigtem Anteil (Clariant)
(6) bestimmt an 0,76 mm Folie laminiert zwischen zwei 2mm dicken Scheiben Optiwhite (Pilkington)
(7) Flächenanteil der in einem Abstand von mehr als 1 cm von der Laminatkante aufgetretenen Blasen und/oder Delaminationen nach Bestrahlungsprüfung gemäß EN 12543 (80°C)
(8) Bestimmt gemäß DIN IEC 60093 bei 23 °C / 85% rLF mit einer Prüfspannung von 2500V in [Ohm*cm].

## Patentansprüche

**1.** Photovoltaikmodul, umfassend ein Laminat aus

a) einer transparenten Frontabdeckung
b) einer oder mehreren photosensitiven Halbleiterschichten
c) mindestens einer weichmacherhaltigen, auf Polyvinylacetal basierenden Folie und
d) einer rückwärtigen Abdeckung **dadurch gekennzeichnet, dass** die weichmacherhaltige, auf Polyvinylacetal basierende Folie c) eine UV-Transmission bei 280 bis 380 nm von mehr als 35 % aufweist, bestimmt zwischen zwei Scheiben Weißglas von 2 mm Dicke nach EN410.

**2.** Photovoltaikmodul nach Anspruch 1 **dadurch gekennzeichnet, dass** das Polyvinylacetal durch Acetalisierung von Polyvinylalkohol hergestellt wird, der in einer 4 Gew.% wässrigen Lösung mit einer Schichtdicke von 1 cm eine Extinktion bei 280 nm von weniger als 0,5 aufweist.

**3.** Photovoltaikmodul nach Anspruch 1 oder 2 **dadurch gekennzeichnet, dass** die auf Polyvinylacetal basierende Folie c) weniger als 0,01 Gew.% UV-Absorber bezogen auf die Folienmischung aufweist.

**4.** Photovoltaikmodul nach einem der Ansprüche 1 bis 3 **dadurch gekennzeichnet, dass** die auf Polyvinylacetal basierende Folie c) 0,001 bis 5 Gew.% nicht-aromatische Lichtstabilisatoren enthält.

**5.** Photovoltaikmodul nach Anspruch 4 **dadurch gekennzeichnet, dass** als nichtaromatischer Lichtstabilisator sterisch gehinderte Amine (HALS) oder sterisch gehinderte Aminoether (NOR-HALS) eingesetzt werden.

**6.** Photovoltaikmodul nach einem der Ansprüche 1 bis 5 **dadurch gekennzeichnet, dass** die weichmacherhaltige, auf Polyvinylacetal basierende Folie mehr als 10 ppm Metallionen ausgewählt aus der Gruppe Erdalkalimetalle, Zink, und Aluminium und weniger als 150 ppm Alkalimetallionen aufweist.

**7.** Photovoltaikmodul nach einem der Ansprüche 1 bis 6 **dadurch gekennzeichnet, dass** die weichmacherhaltigen, auf Polyvinylacetal basierenden Folien c) in einem Umgebungsklima von 85 % rF/23°C einen elektrischen Durchgangswiderstand von mindestens 1 E11 Ohm*cm aufweisen.

**8.** Weichmacherhaltige Folie auf Basis von Polyvinylacetal, **dadurch gekennzeichnet, dass** sie aromatischen UV-Absorber mit einer auf die Folienmischung bezogenen Konzentration unter 0,01 Gew.% und 0,005 bis 1 Gew.% sterisch gehinderte Amine (HALS) und/oder sterisch gehinderte Aminoether (NOR-HALS) als nicht-aromatische

Lichtschutzmittel enthalten.

**9.** Weichmacherhaltige Folie auf Basis von Polyvinylacetal, **dadurch gekennzeichnet, dass** das Polyvinylacetal durch säurekatalysierte Acetalisierung von Polyvinylalkohol hergestellt wird, wobei der Polyvinylalkohol in einer 4 Gew.% wässrigen Lösung mit einer Schichtdicke von 1 cm Extinktionswerte von weniger als 0,5 aufweist.

## Claims

**1.** Photovoltaic module, comprising a laminate made of

a) a transparent front cover
b) one or a plurality of photo-sensitive semiconductor layers
c) at least one polyvinylacetal-based film containing a softening agent, and
d) a rear-facing cover **characterized in that**
the polyvinylacetal-based film (c) containing softening agents has a UV transmittance at 280 to 380 nm of more than 35%, determined between two slices of white glass of 2 mm thickness according to EN410.

**2.** Photovoltaic module according to Claim 1, **characterized in that** the polyvinylacetal is produced by acetalisation of polyvinyl alcohol, which in a 4 wt. % aqueous solution with a layer thickness of 1 cm has an optical absorbance at 280 nm of less than 0.5.

**3.** Photovoltaic module according to Claim 1 or 2, **characterized in that** the polyvinylacetal-based film (c) comprises less than 0.01 wt. % UV absorber as a proportion of the film mixture.

**4.** Photovoltaic module according to any one of Claims 1 to 3, **characterized in that** the polyvinylacetal-based film c) contains 0.001 to 5 wt. % non-aromatic light stabilizers.

**5.** Photovoltaic module according to Claim 4, **characterized in that** as the non-aromatic light stabilizer, sterically hindered amines (HALS) or sterically hindered aminoethers (NOR-HALS) are used.

**6.** Photovoltaic module according to any one of Claims 1 to 5, **characterized in that** the polyvinylacetal-based film containing softening agents comprises more than 10 ppm metal ions selected from the group of alkaline earth metals, zinc and aluminium, and less than 150 ppm alkali metal ions.

**7.** Photovoltaic module according to any one of Claims 1 to 6, **characterized in that** the polyvinylacetal-based films (c) containing softening agents have an electrical pass-through resistance of at least 1E11 Ohm*cm in an ambient climate of 85% rF/23°C.

**8.** Polyvinylacetal-based film containing softening-agents, **characterized in that** they substantially contain aromatic UV absorber with a concentration as a proportion of the film mixture of less than 0.01 wt. % and 0.005 to 1 wt. % sterically hindered amines (HALS) and/or sterically hindered aminoethers (NOR-HALS) as non-aromatic light protection means.

**9.** Polyvinylacetal-based film containing softening-agents, **characterized in that** the polyvinylacetal is produced by acid-catalysed acetalisation of polyvinyl alcohol, wherein the polyvinyl alcohol in a 4 wt. % aqueous solution with a layer thickness of 1 cm has absorbance values of less than 0.5.

## Revendications

**1.** Module photovoltaïque, comprenant un stratifié constitué de :

a) un couvercle frontal transparent,
b) une ou plusieurs couches de semi-conducteur photosensibles,
c) au moins un film contenant du plastifiant, à base de polyvinylacétal et
d) un couvercle arrière **caractérisé en ce que**
le film contenant du plastifiant, à base de polyvinylacétal présente c) une transmission UV à 280 jusqu'à 380

nm de plus de 35%, déterminée entre deux vitres de verre blanc épais de 2 mm conformément à EN410.

2. Module photovoltaïque selon la revendication 1, **caractérisé en ce que** le polyvinylacétal est fabriqué par acétalisation d'alcool polyvinylique, qui présente dans une solution aqueuse à 4% en poids avec une épaisseur de couche de 1 cm une extinction à 280 nm de moins de 0,5.

3. Module photovoltaïque selon la revendication 1 ou 2, **caractérisé en ce que** le film à base de polyvinylacétal présente c) moins de 0.01 % en poids d'absorbeur d'UV par rapport au mélange de feuilles.

4. Module photovoltaïque selon une des revendications 1 à 3, **caractérisé en ce que** le film à base de polyvinylacétal contient c) 0,001 à 5 % en poids de stabilisateurs de lumière non aromatiques.

5. Module photovoltaïque selon la revendication 4, **caractérisé en ce que** comme stabilisateur de lumière non aromatique, des amines à encombrement stérique (HALS) ou des aminoéthers à encombrement stérique (NOR-HALS) sont employés.

6. Module photovoltaïque selon une des revendications 1 à 5, **caractérisé en ce que** le film contenant du plastifiant, à base de polyvinylacétal présente plus de 10 ppm d'ions métalliques sélectionnés dans le groupe des métaux alcalino-terreux, zinc et aluminium et moins de 150 ppm d'ions métalliques alcalins.

7. Module photovoltaïque selon une des revendications 1 à 6, **caractérisé en ce que** les films contenant du plastifiant, à base de polyvinylacétal présentent c) dans un climat ambiant de 85% rF/23°C une résistance volumique électrique d'au moins 1E11 Ohm*cm.

8. Films contenant du plastifiant à base de polyvinylacétal, **caractérisé en ce que** ils contiennent des absorbeurs UV aromatiques avec une concentration rapportée au mélange de feuilles inférieure à 0.01% en poids et 0,005 à 1% en poids d'amines à encombrement stérique (HALS) et/ou des aminoéthers à encombrement stérique (NOR-HALS) comme moyens de protection contre la lumière non aromatiques.

9. Film contenant du plastifiant à base de polyvinylacétal, caractérisé en ce le polyvinylacétal est fabriqué par acétalisation d'alcool polyvinylique, catalysé par acide, dans lequel l'alcool polyvinylique présente dans une solution aqueuse à 4% en poids avec une épaisseur de couche de 1 cm des valeurs d'extinction de moins de 0,5.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 1527107 B1
- WO 2004063231 A1
- EP 1606325 A1
- WO 03020776 A1
- EP 185863 B1
- EP 1118258 B1
- WO 02102591 A1
- EP 387148 B1
- EP 1235683 B1